# EUROPÄISCHE PATENTSCHRIFT

(11) **EP 1 475 910 B1**
(45) Veröffentlichungstag und Bekanntmachung des Hinweises auf die Patenterteilung: **27.05.2015**
(21) Anmeldenummer: 04100979.6
(22) Anmeldetag: 10.03.2004
(51) Int. Cl.: H04H 40/18, H03M 11/10, H04N 5/44

(54) **Wiedergabevorrichtung**
Reproduction apparatus
Dispositif de reproduction

(30) Priorität: 09.05.2003 DE 10320754
(43) Veröffentlichungstag der Anmeldung: 10.11.2004
(73) Patentinhaber: ROBERT BOSCH GMBH, 70442 Stuttgart (DE)
(72) Erfinder: Meyer, Christian, 30173 Hannover (DE)

(56) Entgegenhaltungen:
- EP-A2- 0 575 956
- EP-A2- 1 096 453
- WO-A1-00/60854
- JP-A- H0 661 814
- US-A- 6 021 320
- US-A1- 2002 122 079
- US-A1- 2002 132 617
- US-A1- 2003 001 907

## Beschreibung

### Stand der Technik

Die Erfindung geht aus von einer Wiedergabevorrichtung nach der Gattung des Hauptanspruchs. Es sind schon Wiedergabevorrichtungen in Form von Rundfunkempfängern bekannt, die einen Senderwechsel mittels eines Tastendrucks ermöglichen. Durch die Betätigung einer hierzu vorgesehenen Taste wechselt die Wiedergabe des Audiosignals entweder zu einem Sender mit einer höheren oder niedrigeren Frequenz bzw. zu einem nächsten gespeicherten Sender, falls der Radioempfänger über einen Programmspeicher verfügt. Ferner ist es bekannt, zusätzlich zu dem Rundfunksignal auch Datensignale zu übertragen. Insbesondere ist es hierbei bekannt, einen sogenannten Programmtyp (PTY, Programmtypart) mit dem Radiosignal zu übertragen. Mit Hilfe dieser Programmtypen ist es möglich, die Art des Inhalts des Radioprogramms des übertragenden Senders zu charakterisieren, zum Beispiel "klassische Musik", "Informationen" oder "Popmusik". Ohne das Programm prüfen zu müssen, erhält ein Benutzer hierbei eine Information über das Radioprogramm. Hierzu sind auch Radioempfänger bekannt, die es dem Benutzer ermöglichen, einen Programmtyp vorzuwählen, so dass nur Radiosender des entsprechenden Programmtyps ausgegeben oder dem Benutzer zur Auswahl angezeigt werden. Zur Auswahl des Programmtyps sind weitere Bedienelemente vorgesehen, die eine zusätzliche Eingabe eines Benutzers erfordern. Im Allgemeinen muss ein Benutzer zunächst mit einem ersten Bedienelement den Programmtypen wählen und kann anschließend mit einem zweiten Bedienelement dann den von ihm gewünschten Sender auswählen.

Die US 2002/0122079 A1 offenbart eine multimediale Präsentationsvorrichtung, welche es einem Benutzer erlaubt, eine Vielzahl von Funktionen durch Drücken einer einzelnen Taste anzusteuern. Dabei wird eine bestimmte Funktion abhängig von der Dauer der Betätigung der Taste festgelegt.

### Vorteile der Erfindung

Die erfindungsgemäße Wiedergabevorrichtung mit den Merkmalen des Hauptanspruchs hat demgegenüber den Vorteil, dass mit einem Bedienelement sowohl ein Wechsel zwischen zwei Signalquellen, bei einer Betätigung des Bedienelements über einem Anschlag hinaus, aber auch ein Wechsel zwischen Kategorien von Signalquellen möglich ist, ohne dass ein Benutzer von einem ersten Bedienelement auf ein zweites Bedienelement umgreifen muss. Da sich hierdurch auch die Anzahl der Bedienelemente auf einer Bedienoberfläche vermindert, kann der Platzbedarf für eine bequeme Bedienung zudem verringert werden. Die Dateneingabe wird vereinfacht, so dass besonders unter kritischen Umständen, wie zum Beispiel beim Führen eines Kraftfahrzeugs, die Belastung eines Benutzers durch die Bedienung verringert wird.

Durch die in den Unteransprüchen aufgeführten Maßnahmen sind vorteilhafte Weiterbildungen und Verbesserungen der im Hauptanspruch angegebenen Wiedergabevorrichtung möglich. Besonders vorteilhaft ist, eine Identifizierungseinheit zur Identifikation einer Kategorie einer Signalquelle vorzusehen, wobei die Information über die Kategorie der Signalquelle vorzugsweise zusammen mit dem Datensignal selbst an die Wiedergabevorrichtung übertragen wird. Hierdurch kann eine Information über die Kategorie der Signalquelle bequem ausgewertet werden.

Ferner ist vorteilhaft, eine Anzeigeeinheit zur Darstellung einer ausgewählten Signalquelle oder einer ausgewählten Kategorie vorzusehen, so dass ein Benutzer die Eingabe überprüfen kann.

Ferner ist vorteilhaft, die Wiedergabevorrichtung als eine Audioverarbeitungseinrichtung zum Empfang eines Radiosenders vorzusehen, wobei neben den einzelnen Sendern auch ein Programmtyp entsprechend einer Kategorieauswahl ausgewählt werden kann.

Ferner ist vorteilhaft, in einem weiteren Beispiel auch Datensätze entsprechend ausgestaltet wählbar zu machen, so dass zum Beispiel einerseits bei einer kurzen Betätigung zwischen einzelnen Musikstücken auf einem Datenträger und andererseits bei einer Betätigung über einen Anschlag hinaus zwischen einer Wiedergabe von Musikstücken verschiedener Datenträger ausgewählt werden kann. Bevorzugt wird ferner eine optische und/oder akustische Rückmeldung über eine Einstellung gegeben, so dass ein Benutzer eine sichere Rückmeldung über eine von ihm durchgeführte Änderung erhält.

### Zeichnung

Ausführungsbeispiele der Erfindung sind in der Zeichnung dargestellt und in der nachfolgenden Beschreibung näher erläutert.

Es zeigen
- Figur 1: ein Ausführungsbeispiel für eine erfindungsgemäße Wiedergabevorrichtung,
- Figur 2: ein Beispiel, dass nicht zu der vorliegenden Erfindung gehört, für eine Benutzeroberfläche einer Wiedergabevorrichtung,
- Figuren 3a und 3b: weitere Ausführungsbeispiele für erfmdungsgemäße Eingabeelemente,
- Figur 4: einen erfindungsgemäßen Verfahrensablauf.

### Beschreibung des Ausführungsbeispiels

Die erfmdungsgemäße Wiedergabevorrichtung kann für eine beliebige Datenwiedergabe optischer und/oder akustischer Daten verwendet werden, zum Beispiel für Fernsehgeräte oder Audio-Wiedergabegeräte. Insbesondere ist die Erfindung vorteilhaft, wenn für die Bedienung der Wiedergabevorrichtung nur eine begrenzte Bedienoberfläche zur Verfügung steht bzw. ein Benutzer von anderen Aufgaben abgelenkt werden kann. Die vorliegende Erfmdung wird daher am Beispiel eines Autoradios in einem Kraftfahrzeug im Folgenden näher erläutert.

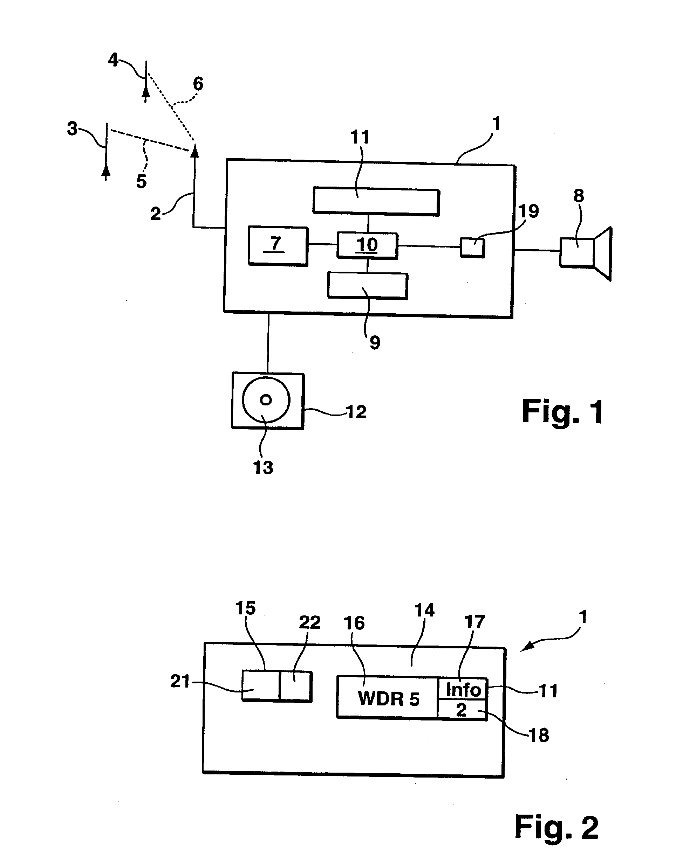

In der Figur 1 ist ein Autoradio 1 dargestellt, an das eine Antenne 2 angeschlossen ist. Die Antenne 2 dient dazu, ein Rundfunkprogramm von einem Radiosender oder Satelliten, im folgenden allgemein als "Sender" bezeichnet, zu empfangen. Bei dem hier dargestellten Ausführungsbeispiel ist ein erster Sender 3 und ein zweiter Sender 4 vorgesehen, wobei der erste Sender 3 ein erstes Radioprogramm 5, dessen Übertragung gestrichelt dargestellt ist, und der zweite Sender 4 ein zweites Radioprogramm 6, dessen Übertragung in der Figur 1 gepunktet dargestellt ist, ausstrahlen. Ebenfalls können die beiden Radioprogramme auch von einem Sender ausgestrahlt werden, der in der Lage ist, mehrere Programme gleichzeitig auszustrahlen. Ferner können auch zusätzliche Informationen, insbesondere Verkehrsinformationen oder Bilddaten, übertragen werden. Das Autoradio 1 verfügt über eine Empfangseinheit 7, die empfangene Radiosignale in Signale zur Audioausgabe über einen Lautsprecher 8 umwandelt. Die Empfangseinheit 7 ist ferner dazu ausgelegt, zusätzliche, mit den Rundfunksignalen 5, 6 übertragene, codierte Informationen zu ermitteln, zu verarbeiten und an die Recheneinheit 10 zur weiteren Verarbeitung und/oder zur Ausgabe über die Anzeigeeinheit 11 und/oder den Lautsprecher 8 auszugeben. Ferner verfügt das Autoradio 1 über eine Bedieneinheit 9 mit in der Figur 1 nicht näher dargestellten Bedienelementen, die über eine Recheneinheit 10 ausgewertet werden. Über die Bedieneinheit 9 eingestellte Betriebsparameter des Autoradios 1 werden in einer Anzeigeeinheit 11 zur Anzeige gebracht. In einer bevorzugten Ausführungsform des Autoradios 1 ist ein Datenträgerlaufwerk 12 mit mindestens einem darin einlegbaren Datenträger 13, zum Beispiel einer CD-ROM, an das Autoradio 1 angeschlossen. Dabei kann ebenfalls eine Audioausgabe von auf dem Datenträger 13 gespeicherten Audioinformationen durch das Autoradio 1 mittels des Lautsprechers 8 erfolgen.

Die Recheneinheit 10 ist nun in der Weise mit der Bedieneinheit 9 verbunden, dass über eine Betätigung der Bedieneinheit 9 zwischen einer Wiedergabe der verschiedenen Sender 3, 4 ausgewählt werden kann. Die Bedieneinheit 9 weist hierzu einen Kippschalter oder einem Drehregler auf. Zur Speicherung von Sendern und/oder von Informationen zu Sendern weist das Autoradio 1 eine Speichereinheit 19 zum vorzugsweise nichtflüchtigen Ablegen von Senderinformationen auf.

In der Figur 2 ist ein Beispiel, dass nicht zu der vorliegenden Erfindung gehört, für eine Benutzeroberfläche des in der Figur 1 dargestellten Autoradios 1 gezeigt. An einer Bedienoberfläche 14 des Autoradios ist die Anzeigeeinheit 11 angebracht, neben der seitlich ein Bedienelement 15 vorgesehen ist. Weitere gegebenenfalls vorhandene Bedienelemente auf der Bedienoberfläche 14 sind in der Figur 2 aus Gründen der Übersichtlichkeit der Zeichnung nicht dargestellt. In der Anzeigeneinheit 11 ist in einem ersten Anzeigefeld 16 ein Sendername dargestellt. In einem zweiten Anzeigefeld 17 wird eine ein Programmtyp des eingestellten Senders angezeigt. In einem bevorzugten Ausführungsbeispiel ist zusätzlich eine Programmnummer 18 dargestellt, die den Programmplatz eines in dem Autoradio 1 gespeicherten, ausgewählten Senders angibt.

Das Bedienelement 15 ist gemäß dem in der Figur 2 dargestellten Beispiel als eine Wippe mit einem ersten Bedienfeld 21 und einem zweiten Bedienfeld 22 ausgeführt. In einem ersten Beispiel sind die beiden Bedienfelder 21, 22 derart miteinander verbunden, dass ein Hineindrücken eines der Bedienfelder in die Bedienoberfläche 14 ein Hinausdrücken des jeweils anderen Bedienfelds aus der Bedienoberfläche 14 hervorruft. Eine Betätigung eines der beiden Bedienfelder 21, 22 wird elektrisch ermittelt und hierdurch der Recheneinheit 10 zugeführt. In einem weiteren Beispiel können die beiden Bedienfelder 21 und 22 auch getrennt ausgeführt sein. Bevorzugt bilden sie jedoch durch eine zumindest benachbarte Anordnung funktionell eine Einheit als ein Bedienelement.

Mit einer kurzen Betätigung eines der Bedienfelder 21, 22 erfolgt ein Wechsel des eingestellten Senders. In einer ersten Betriebsart wird bei einer Betätigung des ersten Bedienelements ein nächster, empfangbarer Sender gesucht, dessen Frequenz niedriger als der bisher eingestellte Sender ist. Bei einer Betätigung des zweiten Bedienfeldes 22 wird ein nächster empfangbarer Sender mit einer höheren Frequenz als der derzeit eingestellte Sender gesucht. In einer weiteren Betriebsart, bei der das Autoradio 1 über voreingestellte Programmplätze verfügt, wird bei einer Betätigung des ersten Bedienfelds 21 ein Sender eingestellt, dessen Programmplatz um eins niedriger ist, als der Programmplatz des derzeit eingestellte Senders. Bei einer Betätigung des zweiten Bedienfeldes 22 wird entsprechend der gewählte Programmplatz um eins erhöht. Bei einem besonderen Beispiel wird dabei sichergestellt, dass der ausgewählten Sender dem gleichen Programmtyp angehört, wie der zuvor eingestellte Sender. Somit wird ein Wechsel des eingestellten Senders innerhalb des derzeit eingestellten Programmtyps durchgeführt.

Wird nun eines der beiden Bedienfelder 21, 22 länger als ein vorgegebener Zeitraum, zum Beispiel länger als 1 Sekunde, gedrückt gehalten, so wird der eingestellte Sender nicht bezüglich der Frequenz oder des Programmplatzes gewechselt, sondern ein eingestellte Programmtyp wird geändert. Bei der gemäß der Anzeige in dem zweiten Anzeigenfeld 17 derzeit eingestellten Programmart "Info" wird durch eine Betätigung des ersten Bedienfeldes 21 bei dem hier vorliegenden Autoradio zum Beispiel zu einem Sender des Programmtyps "Popmusik" und bei einer Betätigung des zweiten Bedienfelds 22 zu einem Sender des Programmtyps "Klassische Musik" gewechselt. Neben den bisher bekannten Programmtypen sind beliebige, andere Programmtypen denkbar, die für eine entsprechende Auswahl vorgesehen sein können. Dies ist insbesondere vorteilhaft für den Empfang digitaler Rundfunkprogramme, da zum Beispiel distales Satelliten-Radio oder DAB (Digital Audio Broadcasting) eine derart große Programmvielfalt anbieten, dass eine Auswahl zwischen einzelnen Sendern anhand der Sendernamen oder der Frequenzen ein umfangreiches Wissen über die Inhalte der einzelnen Programme bei einem Benutzer voraussetzt. Ferner ist es möglich, anstelle des Programmtyps auch eine andere Kategorisierung von Radiosendern vorzunehmen. Dies kann z.B. eine regionale Zugehörigkeit oder eine verbesserte bzw. verfeinerte Programmtypzuordnung sein.

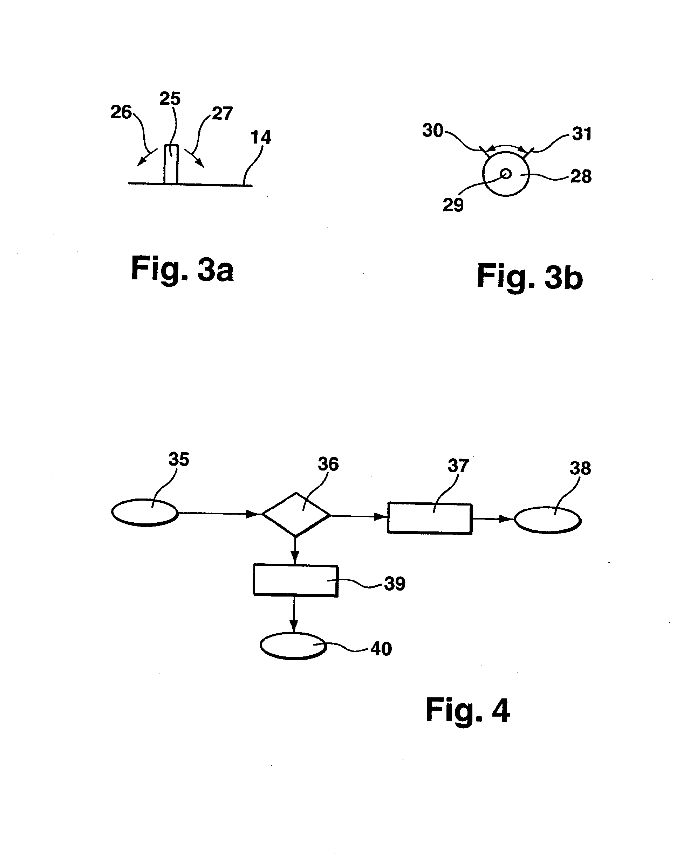

In der Figur 3a ist ein Kippschalter 25 in Seitenansicht dargestellt, der aus der Bedienoberfläche 14 hinausragt. Der Kippschalter 25 ist in eine erste Richtung 26 und in eine entgegengesetzte, zweite Richtung 27 kippbar. Das Kippen in die erste Richtung 26 entspricht dabei einer Betätigung des ersten Bedienfeldes 21 und das Kippen in die zweite Richtung 27 einer Betätigung des zweiten Bedienfelds 22.

In der Figur 3b ist ein weiteres Bedienelement in Form eines Drehreglers 28 in Aufsicht dargestellt, der um eine Drehachse 29 gedreht werden kann. Der Drehregler ist dabei vorzugsweise so ausgeführt, dass er entgegengesetzt sowohl zu einem ersten Anschlag 30, als auch zu einem zweiten Anschlag 31 gedreht werden kann. Das Drehen nach links zu dem ersten Anschlag 30 entspricht dabei einer Betätigung des ersten Bedienfeldes 21, eine Drehung zu dem zweiten Anschlag 31 einer Betätigung des zweiten Bedienfelds 22.

Erfindungsgemäß wird an Stelle einer Zeitschranke, unterhalb der ein Senderwechsel und oberhalb der ein Kategoriewechsel in Form eines Programmtypwechsels vorgesehen wird, für die Bedienelemente 25, 28 ein Anschlag vorgesehen, der eine entsprechende Benutzeraktion regelt. Wird das Bedienelement jeweils nur bis zu diesem Anschlag betätigt, erfolgt lediglich ein Senderwechsel. Wird das Bedienelement über den Anschlag hinaus betätigt, wird also zum Beispiel, der Kippschalter 25 über einen entsprechenden Anschlag hinaus verkippt oder der Drehregler 28 über den ersten Anschlag 30 hinaus bewegt, so erfolgt an Stelle eines Senderwechsels ein Kategoriewechsel des eingestellten, wiedergegebenen Senders.

In der Figur 4 ist ein erfindungsgemäßer Verfahrensablauf dargestellt. Ausgehend von einem Initialisierungsschritt 35, mit dem eine Bedienung eines Bedienelements erfasst wird, wird zu einem Entscheidungsschritt 36 verzweigt In dem Entscheidungsschritt 36 wird überprüft, ob das Bedienelement über einen vorgesehenen Anschlag hinaus ausgelöst wurde. Ist dies nicht der Fall, so wird zu einem Senderwechselschritt 37 verzweigt, indem der eingestellte Sender entsprechend dem betätigten Bedienelement bzw. der betätigten Aktion gewechselt wird. Dabei erfolgt ein Senderwechsel zwischen Sendern des gleichen, derzeit eingestellten Programmtyps. Ein Wechsel der Kategorie eines ausgewählten Senders wird nicht vorgenommen. Ist zum Beispiel der Programmtyp "Popmusik" eingestellt, so wird zwischen solchen Sendern umgeschaltet, die dem gleichen Programmtyp "Popmusik" angehören. Das Verfahren wird anschließend mit einem Endschritt 38 beendet.

Wird in dem Entscheidungsschritt 36 dagegen festgestellt, dass der Anschlag überschritten wurde, so wird zu einem Kategoriewechselschritt 39 verzweigt, indem zum Beispiel ein anderer Programmtyp eingestellt wird. Zum Beispiel wird von dem Programmtyp "Popmusik" zu dem Programmtyp "Informationen" gewechselt.

Auch der Wechsel des Programmtyps ist in der Regel mit einem Wechsel des eingestellten Senders verbunden, es sei denn, ein Sender ist zwei verschiedenen Programmtypen zugeordnet. Nach einer Zuordnungsvorschrift wird dabei zum Beispiel in einer alphabetischen Reihenfolge von Sendernamen ein erster Sender ausgewählt, der dem entsprechenden Programmtyp zugeordnet ist. Jedoch ist auch eine beliebige, andere Auswahl innerhalb der Kategorie möglich, z.B. der zuletzt gewählte Sender in der jeweiligen Kategorie oder eine bevorzugte Senderwahl eines Benutzers in der jeweiligen Kategorie. Das Verfahren wird anschließend ebenfalls in einem Endschritt 40 beendet.

An Stelle einer Auswahl eines Sendernamens ist es erfindungsgemäß auch möglich, dass als Signalquellen einzelne Dateien mit wiederzugebenden Daten angesehen werden, zum Beispiel Video- und/oder Audiodaten. Als einzelne Signalquellen sind z.B. jeweils die Daten einzelner Musikstücke anzusehen. Diese Dateien sind einzelnen Kategorien, zum Beispiel einzelnen Verzeichnissen oder Datenträgern zugeordnet. Als eine Kategorie von Daten kann z.B. die Zugehörigkeit eines Musikstücks zu einem Datenträger angesehen werden, auf dem es gespeichert ist oder auf dem es ursprünglich einmal gespeichert war.

Mit einem kurzen Druck, zum Beispiel auf eines der Bedienfelder 21, 22 kann zwischen den Dateien einer Kategorie, also z.B. eines Datenträgers, gewechselt werden. Hierzu ist das Datenträgerlaufwerk 12 in der Lage, mehrere Datenträger aufzunehmen. Ferner kann der Speicherplatz in dem Datenträgerlaufwerk 12, z.B. bei der Ausführung als ein Festplattenläufwerk, auch so groß sein, dass die Daten mehrerer herkömmlicher Musikdatenträger, also z.B. mehrere CD-ROM, aufgenommen werden können. Wird ein vorgegebener Anschlag überschritten, so wird zu einer nächsten Kategorie, also zum Beispiel zu einem nächsten Verzeichnis von Musik- oder Videodaten oder zur Wiedergabe von Daten von einem anderen Datenträger umgeschaltet und die Wiedergabe wird mit der Wiedergabe einer der Dateien des anderen Datenträgers bzw. des anderen Dateienverzeichnisses fortgeführt.

## Patentansprüche

1. Wiedergabevorrichtung mit einem Eingabeelement (9, 21, 22, 25, 28) für eine Auswahl einer Signalquelle (3, 4, 13) zur Verarbeitung und Ausgabe von Signalen der Signalquelle (3,4,13) durch die Wiedergabevorrichtung (1), wobei auswählbare Signalquellen (3, 4, 13) einer Kategorie von Signalquellen zugeordnet sind, wobei durch eine Betätigung des Eingabeelements (9, 21, 22, 25, 28) bis zu einem Anschlag (30, 31) ein Wechsel von einer Wiedergabe einer ersten Signalquelle zu einer Wiedergabe einer zweiten Signalquelle derselben Kategorie erfolgt, **dadurch gekennzeichnet, dass** das Eingabeelement (9, 21, 22, 25, 28) so ausgeführt ist, dass bei einer Betätigung des Eingabeelements (9, 21, 22, 25, 28) über den Anschlag (30, 31) hinaus von einer Wiedergabe einer Signalquelle einer ersten Kategorie zu einer Wiedergabe einer Signalquelle einer zweiten Kategorie gewechselt wird, wobei das Eingabeelement (9, 21, 22, 25, 28) ein Kippschalter (25) oder ein Drehregler (28) ist.,

2. Wiedergabevorrichtung nach Anspruch 1, **gekennzeichnet durch** eine Identifizierungseinheit (7) zur Identifikation einer Kategorie einer Signalquelle aus zu der Wiedergabevorrichtung (1) übertragenen Signalen.

3. Wiedergabevorrichtung nach einem der vorherigen Ansprüche, **gekennzeichnet durch** eine Anzeigeeinheit (11) zur Darstellung der ausgewählten Signalquelle und/oder der ausgewählten Kategorie.

4. Wiedergabevorrichtung nach einem der vorherigen Ansprüche, **dadurch gekennzeichnet, dass** die Wiedergabevorrichtung (1) eine Audioverarbeitungsvorrichtung zur Umwandlung des Signals der Signalquellen (3, 4, 13) in ein über eine Ausgabeeinheit (8) auszugebendes Audiosignal ist.

5. Wiedergabevorrichtung nach Anspruch 4, **dadurch gekennzeichnet, dass** die Signalquellen (3, 4) Radiosender sind.

6. Wiedergabevorrichtung nach Anspruch 5, **dadurch gekennzeichnet, dass** die Kategorien Programmtypen von Radiosendern sind.

7. Wiedergabevorrichtung nach einem der Ansprüche 1-4, **dadurch gekennzeichnet, dass** die Signalquellen Dateien sind und die Kategorien jeweils festgelegte Gruppe von Dateien sind.

8. Verfahren zur Auswahl einer Signalquelle mittels eines Eingabeelements zur Wiedergabe von Daten aus der Signalquelle, wobei eine Betätigung des Eingabeelements erfasst wird und wobei durch eine Betätigung des Eingabeelements bis zu einem Anschlag ein Wechsel von einer ersten Signalquelle zu einer zweiten Signalquelle einer gleichen Kategorie von Signalquellen erfolgt, **dadurch gekennzeichnet, dass** das Eingabeelement ein Kippschalter oder ein Drehregler ist, und dass wenn der Kippschalter über den Anschlag hinaus verkippt oder der Drehregler über den Anschlag hinaus bewegt wird, ein Wechsel von einer Wiedergabe einer Signalquelle einer ersten Kategorie zu einer Wiedergabe einer Signalquelle einer zweiten Kategorie erfolgt.

9. Verfahren nach Anspruch 8, **dadurch gekennzeichnet, dass** eine Information über die Kategorie einer Signalquelle mit dem Signal von der Signalquelle übertragen wird.

10. Verfahren nach einem der Ansprüche 8-9, **dadurch gekennzeichnet, dass** eine akustische und/oder optische Rückmeldung über den Wechsel der Signalquelle und/oder den Wechsel der Kategorie ausgegeben wird.

## Claims

1. Reproduction apparatus having an input element (9, 21, 22, 25, 28) for selection of a signal source (3, 4, 13) for processing and output of signals from the signal source (3, 4, 13) by the reproduction apparatus (1), wherein selectable signal sources (3, 4, 13) are associated with a category of signal sources, wherein operation of the input element (9, 21, 22, 25, 28) as far as a stop (30, 31) effects a change from reproduction of a first signal source to reproduction of a second signal source in the same category, **characterized in that** the input element (9, 21, 22, 25, 28) is embodied such that operation of the input element (9, 21, 22, 25, 28) beyond the stop (30, 31) prompts a change from reproduction of a signal source in a first category to reproduction of a signal source in a second category, the input element (9, 21, 22, 25, 28) being a toggle switch (25) or a rotary control (28).

2. Reproduction apparatus according to Claim 1, **characterized by** an identification unit (7) for identifying a category of a signal source from signals transmitted to the reproduction apparatus (1).

3. Reproduction apparatus according to either of the preceding claims, **characterized by** a display unit (11) for presenting the selected signal source and/or the selected category.

4. Reproduction apparatus according to one of the preceding claims, **characterized in that** the reproduction apparatus (1) is an audio processing apparatus for converting the signal from the signal source (3, 4, 13) into an audio signal that can be output via an output unit (8).

5. Reproduction apparatus according to Claim 4, **characterized in that** the signal sources (3, 4) are radio stations.

6. Reproduction apparatus according to Claim 5, **characterized in that** the categories are program types from radio stations.

7. Reproduction apparatus according to one of Claims 1-4, **characterized in that** the signal sources are files and the categories are respectively stipulated groups of files.

8. Method for selection of a signal source by means of an input element for the purpose of reproducing data from the signal source, wherein operation of the input element is sensed and wherein operation of the input element as far as a stop effects a change from a first signal source to a second signal source in an identical category of signal sources, **characterized in that** the input element is a toggle switch or a rotary control, and **in that** if the toggle switch is tilted beyond the stop or the rotary control is moved beyond the stop then there is a change effected from reproduction of a signal source in a first category to reproduction of a signal source in a second category.

9. Method according to Claim 8, **characterized in that** a piece of information about the category of a signal source is transmitted with the signal from the signal source.

10. Method according to either of Claims 8-9, **characterized in that** audible and/or visual feedback about the change of signal source and/or the change of category is output.

## Revendications

1. Dispositif de reproduction comportant un élément d'entrée (9, 21, 22, 25, 28) permettant de sélectionner une source de signal (3, 4, 13) afin de traiter et de fournir en sortie des signaux de la source de signal (3, 4, 13) au moyen du dispositif de reproduction (1), dans lequel des sources de signaux pouvant être sélectionnées (3, 4, 13) sont affectées à une catégorie de sources de signaux, dans lequel un basculement d'une reproduction d'une première source de signal à une reproduction d'une seconde source de signal de la même catégorie est effectué par actionnement de l'élément d'entrée (9, 21, 22, 25, 28) jusqu'à une butée (30, 31), **caractérisé en ce que** l'élément d'entrée (9, 21, 22, 25, 28) est réalisé de manière à ce que, lors d'un actionnement de l'élément d'entrée (9, 21, 22, 25, 28) au-delà de la butée (30, 31), un basculement soit effectué d'une reproduction d'une source de signal d'une première catégorie à une reproduction d'une source de signal d'une seconde catégorie, dans lequel l'élément d'entrée (9, 21, 22, 25, 28) est un interrupteur à bascule (25) ou une molette (28).

2. Dispositif de reproduction selon la revendication 1, **caractérisé par** une unité d'identification (7) destinée à identifier une catégorie d'une source de signal à partir de signaux transmis au dispositif de reproduction (1).

3. Dispositif de reproduction selon l'une quelconque des revendications précédentes, **caractérisé par** une unité d'affichage (11) destinée à afficher la source de signal sélectionnée et/ou la catégorie sélectionnée.

4. Dispositif de reproduction selon l'une quelconque des revendications précédentes, **caractérisé en ce que** le dispositif de reproduction (1) est un dispositif de traitement audio destiné à convertir le signal de la source de signal (3, 4, 13) en un signal audio devant être reproduit par l'intermédiaire d'une unité de reproduction (8).

5. Dispositif de reproduction selon la revendication 4, **caractérisé en ce que** les sources de signaux (3, 4) sont des émetteurs radio.

6. Dispositif de reproduction selon la revendication 5, **caractérisé en ce que** les catégories sont des types de programmes d'émetteurs radio.

7. Dispositif de reproduction selon l'une quelconque des revendications 1-4, **caractérisé en ce que** les sources de signaux sont des fichiers et **en ce que** les catégories sont respectivement des groupes déterminés de fichiers.

8. Procédé de sélection d'une source de signal au moyen d'un élément d'entrée pour reproduire des données provenant de la source de signal, dans lequel un actionnement de l'élément d'entrée est détecté et dans lequel un basculement d'une première source de signal à une seconde source de signal d'une même catégorie de sources de signaux est effectué par un actionnement de l'élément d'entrée jusqu'à une butée, **caractérisé en ce que** l'élément d'entrée est un interrupteur à bascule ou une molette, et **en ce que**, lorsque l'interrupteur à bascule est incliné au-delà de la butée ou lorsque la molette est déplacée au-delà de la butée, un basculement est effectué d'une reproduction d'une source de signal d'une première catégorie à une reproduction d'une source de signal d'une seconde catégorie.

9. Procédé selon la revendication 8, **caractérisé en ce qu'**une information concernant la catégorie d'une source de signal est transmise avec le signal de la source de signal.

10. Procédé selon l'une quelconque des revendications 8-9, **caractérisé en ce qu'**une rétroaction acoustique et/ou optique est délivrée par l'intermédiaire du basculement de la source de signal et/ou du basculement de la catégorie.
